# EUROPEAN PATENT SPECIFICATION

(11) **EP 1 224 812 B1**
(45) Date of publication and mention of the grant of the patent: **22.12.2004**
(21) Application number: 00974485.5
(22) Date of filing: 26.10.2000
(51) Int. Cl.: H04Q 1/02, H04Q 1/10, H05K 5/00, H05K 7/18, H02B 1/30

(54) **UNIT HOUSING CELL EQUIPMENT FOR CELLULAR TELEPHONES**
EINHEIT ZUM UNTERBRINGEN VON MOBILFUNK AUSRÜSTUNG
UNITE ABRITANT LES EQUIPEMENTS CELLULAIRES DESTINES AUX TELEPHONES CELLULAIRES

(30) Priority: 28.10.1999 EP 99203561
(43) Date of publication of application: 24.07.2002
(73) Proprietor: N.V. Belgacom Mobile S.A., 1210 Brussels (BE)
(72) Inventor: VINKX, Philip, B-1210 Brussels (BE); BAUWERAERTS, Koen, B-1210 Brussels (BE)
(74) Representative: Van Straaten, Joop
(86) International application number: PCT/EP2000/010679
(87) International publication number: WO 2001/031931

(56) References cited:
- WO-A-98/47339
- US-A- 5 398 159

## Description

The invention relates to a service protection structure housing cell equipment for cellular telephones including radio equipment and supporting equipment for providing protection of said cell equipment.

Such service protection structures are known and used wide-spread in cellular telephones systems.

An example of such a service protection structure is given in United States patent US 5,911,117. In US 5,911,117 a unit is described which is a fixed structure. The structure, a so-called services protection structure (SPE), houses radio equipment (BTS) as well as supporting equipment inside the structure. The structure itself is a large cabinet on a concrete pad within which there are compartments provided for housing various types of equipment. Such structure provide protection against unauthorised persons and/or environmental conditions, such as rain, storm, dust.

Although this known service protection structure has advantageous properties, more in particular installation of various equipment can be better planned, there are mayor disadvantages. The structure takes up space and once placed cannot be moved.

US 5,991,117 discloses a service protection structure designed for outdoor use. For indoor use commonly a room is used which is sheltered from disturbing electromagnetic radiation, and in which room equipment such as BTS and supporting equipment is placed.

Such 'indoor units' are expensive and require a relatively large room to be used for the unit.

As more and more cellular telephones are used, the need for service protection structures housing cell equipment for cellular telephones increases. At the same time as the need for such structures increases there is a trend to impose ever more restrictions on the available place for such a structure, for instance building permits being refused for building such units at sites where the view may be obstructed and ever more emphasis is placed on flexibility, i.e. the freedom to place such units at a desired position and, if needed to remove them again. Such flexibility should not, however, infer with the protection offered by the service protection structure.

Using the above described known service protection structure it is difficult if possible at all to meet these conflicting demands.

It is an object of the invention to provide for a service protection structure housing cell equipment for cellular telephones which is better capable of meeting the above demands.

To this end the service protection structure is characterised in that the service protection structure comprises two or more separately movable cabinets the outer sides of which are substantially made of metal material, a first of said cabinets housing the radio equipment, a second of said cabinets housing the supporting equipment, each cabinet having means to join a side to a corresponding side of an adjoining cabinet and each of the cabinets having means for cables going from said cabinet to the adjoining cabinet through said joining sides, the assembly of the cabinets substantially forming the service protection structure.

With 'outer sides' are meant the sides (including top and bottom) that do not get joined when the two cabinets are joined. Preferably however, also these joining sides are also substantially made of metal material. 'Substantially made of metal material' includes metal sides which may be provided with coatings of non-metal nature (protective coatings of some sort), paint and other material. Metal includes metal alloys and metal compositions (steel, aluminium alloys etc.). The sides substantially made of metallic material may also comprise metallic material in or on a plastic material substrate.

Compared to the known indoor structures the invention offers the great advantage that it is not needed to use (sacrifice) a room for the structure. The structure substantially forms a cage of Faraday (due to the metal outer sides of the cabinets) substantially sheltering the equipment inside the structure from stray electromagnetic interference. It is thus not needed to shelter a complete room. Another advantage is that the cabinets can be moved separately to the place where the unit is to be located. Thus the cabinets may be for instance moved to a cellar or attic, although the structure as a whole would never pass the stairs leading up to (down to) said attic or cellar. Thus the structure can be installed in spaces (public and private) which before could not be used for housing cell equipment. Preferably the cabinet housing the radio equipment houses the radio equipment but not the supporting equipment and/or electrical supply equipment such as batteries. Radio equipment may be for instance an BTS system. Preferably, and this holds for indoor as well as outdoor service protection structures, the radio equipment is provided as a removable unitary assembly inside the housing. In these embodiments the radio equipment may be removed and if necessary replaced or serviced in its entirety from the unit. Preferably the service protection structure is provided with a slide for placing the radio equipment upon. The supporting equipment as well as in preferred embodiments electrical supply equipment is housed in the cabinet for the supporting equipment. Such a dissection of functions over the cabinets gives the important advantage over embodiments in which the cabinet housing radio equipment houses also part of the supporting equipment that the radio and supporting equipment can be services and swapped, if needed, independently. These embodiments are in particular of importance if the structure comprise more than one cabinet of one kind combined with one or more cabinets of the other kind. Both types of cabinets form autonomous entities. Preferably the radio equipment is placed on a slide, which can be slit in and out of the cabinet housing the radio equipment. This reduces strongly the time needed during replacement of or servicing or repair of the radio equipment. Preferably the door and the relevant cabinet is arranged for accommodating most, preferably all indoor radio equipment units. In practice this means that, compared to such radio equipment units, the dimensions of the door, cabinet and slide are oversized. Preferably the cabinets comprise wall elements and a frame which are detachable from and attachable to each other by means of reversible attachment means. In these preferred embodiments the cabinets can be taken apart and (re)assembled at the desired place. This further increases the possible places in which the structure can be used. Preferably the frame also comprises frame elements which can be detached from and attached to each other. Another advantage of the structure in accordance with the invention over known indoor 'structure' is the fact that the interference with stray signals is reduced. In the known indoor 'structures' the radio equipment and the supporting equipment are linked with cables which, although sheltered from interference from outside, are not so well sheltered from stray sources inside the room. Furthermore it is very difficult to fully shelter a room. Leaks (for instance windows or doors) occur. A room with many windows is very difficult to shelter. In the structure in accordance with the invention the equipment is placed in a closed cage of Faraday, formed by the structure enabling the structure to be positioned for instance in a room with many windows or some public hall way, without fear of interference. As stated before preferably also the joining sides of the two cabinets are made of metal. This results in at least some cross-interference between the radio and supporting equipment being eliminated.

Preferably the two cabinets are provided with means for lifting the cabinets, either from the top (for instance hooks or eyes) or from the bottom (for instance holes to stick the teeth of a lift truck in).

Preferably at least one of the cabinets has means for joining a further cabinet to the structure. Cabinets can be added at either side (left and right) of such a least one of the cabinet.

This enables for instance to build a structure comprising one cabinet housing controlling equipment joined with two or more cabinets housing radio equipment. This modular approach (i.e. a unit can comprise a number of joined cabinets) has a number of advantages. It restricts the needed space, yet without sacrificing flexibility. Replacement or service of equipment be it radio equipment or supporting equipment can be done with very little time loss. To a structure which comprises a cabinet having supporting equipment and an adjoining cabinet having radio equipment to be replaced or serviced, an additional cabinet having radio equipment is adjoined for instance to a 'free' side of the cabinet having supporting equipment. The radio equipment of said additional cabinet is checked or calibrated or prepared to be connected. When all preparations are made, the cables connecting the supporting equipment to the radio equipment in the first cabinet with radio equipment are detached, and connected to the radio equipment in the additional cabinet. This takes very little time. The first cabinet with radio equipment can now be detached (separated) from the structure and removed, repaired or serviced without any problems and without stopping the transmission of the unit.

It is remarked that from PCT application WO 98/47339 and from US patent 5,398,159 modular rack systems for electronic equipment are known. Such rack systems, however, do not form units,service protection structures, since they do not protect against unauthorised persons, and/or environmental influences. They are basically storing racks for electronic equipment, i.e packaging systems. It is described that such racks may be placed in a cabinet, but no specific details on such cabinets relevant to the present invention are described in PCT application WO 98/47339 and/or US patent 5,398,159.

These and other objects of the invention will be apparent from and elucidated with reference to the embodiments described hereinafter.
Figs. 1A to 1C show a service protection structure in accordance with the invention for indoor use.
Fig. 2a to 2D show a service protection structure in accordance with the invention for indoor use comprising two cabinets with radio equipment.
Figs. 3 to 5 show a service protection structure in accordance with the invention for outdoor use.

The Figures are not drawn to scale. In the Figures, like reference numerals generally refer to like parts.

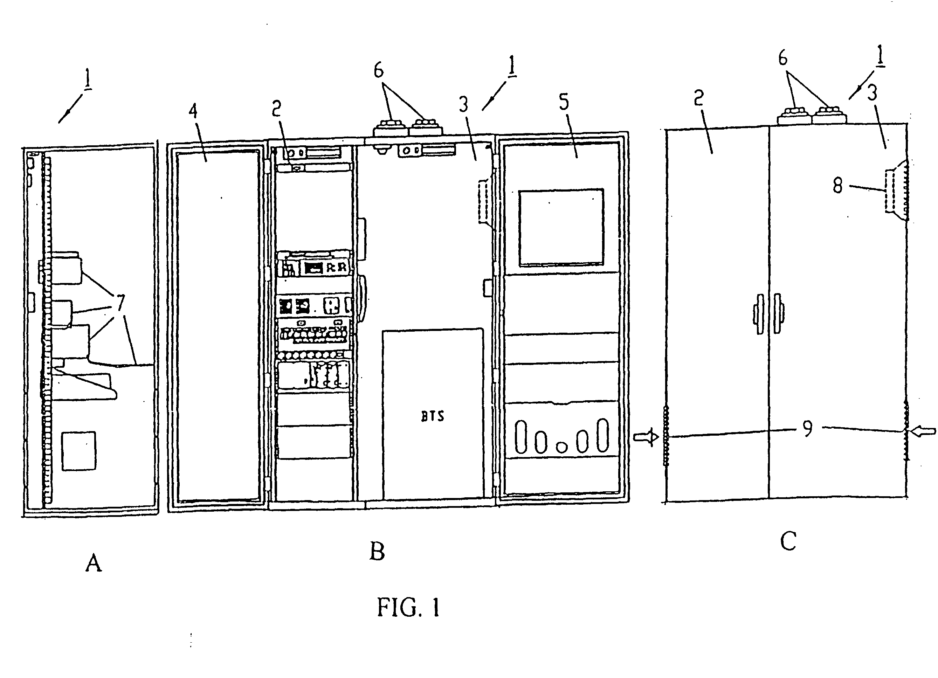

Fig. 1A shows a open side view of a structure in accordance with the invention, Fig. 1B a frontal view with opened doors and Fig. 1C a frontal view with closed doors.

The structure 1 comprises two cabinets 2 and 3. The cabinets form each separately movable cabinets. Said cabinets can be moved as independent modules and the service protection structure can be assembled at the required location. In this example the left hand cabinet 2 houses supporting equipment 7 behind door 4. The right-hand cabinet houses radio equipment (a BTS, Base transceiver station, unit) behind door 5. Connections 6 for connection to antenna's are also provided. Such connection can be also provided in cabinet 2 on various sides. Cabinet 3 also comprise a fan 7 and grills 9 for fresh air and cooling. When the two cabinets are joined the doors are closed (fig. 1C) by which means protection against unauthorised persons is provided. When the two cabinets are joined the strcture is substantially formed. 'Substantially formed' does not exclude that some accessory details are added to the structures after joining the unit together such as a fire extinguisher, a coat of paint, a brace to attach to a wall etc. As explained above the modular approach renders several advantages. This structure may indoor be used at places where before such structure could not be used, for instance in rooms which due to for instance the presence of windows or large disturbing electro-magnetic fields could not be used. It can even be used in places which do not provide access to a structure having the size of the structure shown in figs. 1A to 1C. All that is required is an access large enough to pass the largest of the two cabinets (in this example the right hand cabinet) in case the cabinets are assembled/manufactured outside the place. Especially in those circumstances where the structure comprises more than two cabinets, this is a distinct advantage. In case the cabinets (or at least the larger of the cabinets) comprises wall and frame elements which can be taken apart and reassembled at will by reversible attachment means, the flexibility of the unit is even greater, because the access only has to be large enough to enable the largest of said elements to pass. If one of the cabinets needs to be replaced and/or the equipment needs to be serviced, such can be easily done without unduly interrupting the transmission, as explained above. Preferably all cable throughputs to the outside of the cabinet are substantially airtight as are all doors, the structure thus, in closed status being substantially airtight and the structure is on the inside provided with a fire detection system and a CO₂ fire extension system. Such provision increases greatly the protection offered. Beginning fires are safely extinguished inside the unit. This also increases the number of places in which the structure may be placed. Some places required namely an increased level of fire safety.

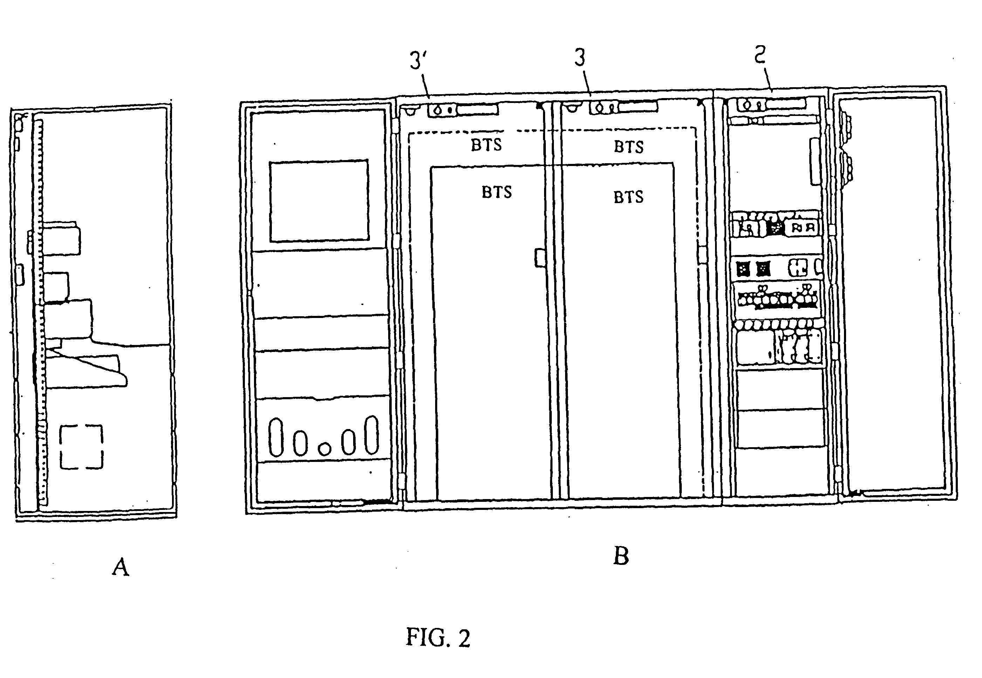

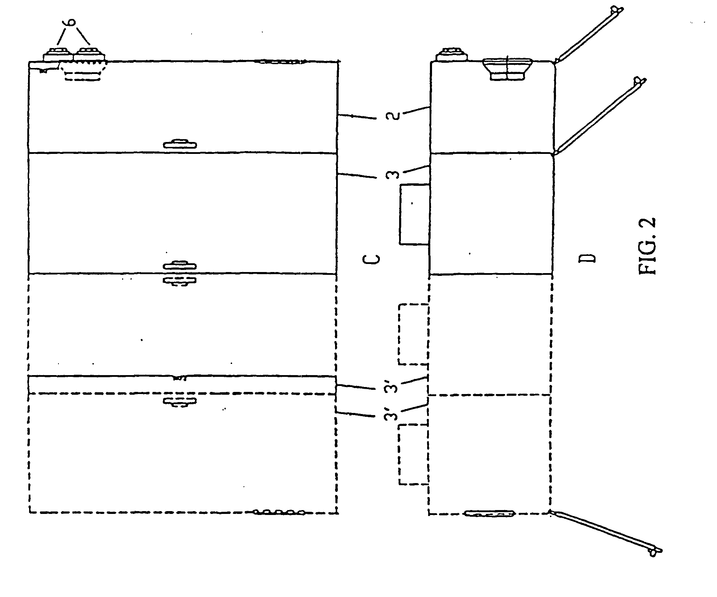

Figs. 2a to 2D show in respectively open side view, front view with open doors, front view with closed doors and top view, in more detail a further embodiment of the structure in accordance with the invention. In this embodiment next to cabinet 3 a further cabinet 3' is integrated into the structure. This structure also houses radio equipment.

Figs. 1A to 2D show a structure primarily used for/designed for indoor use.

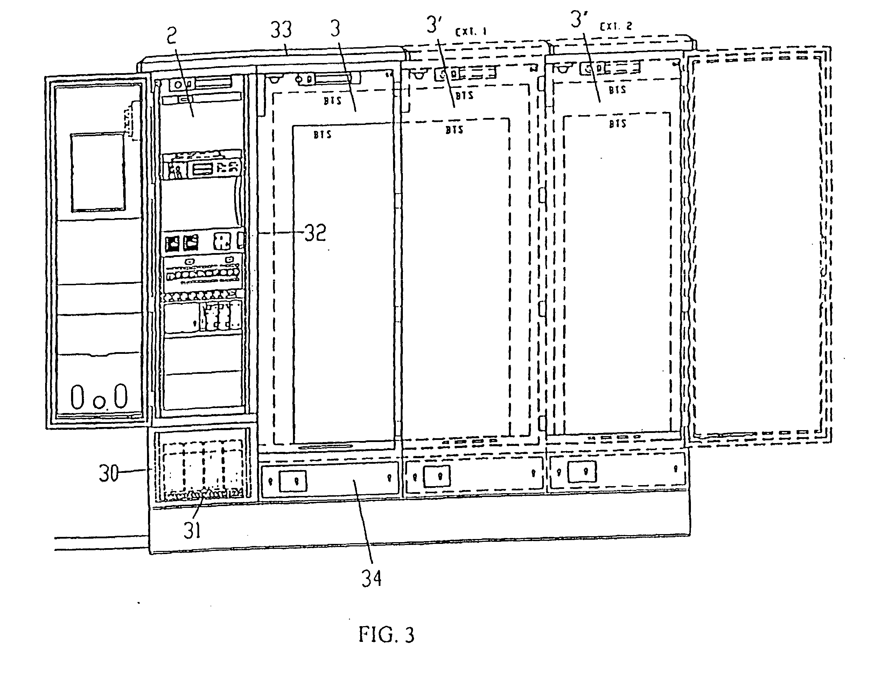

Figs. 3 to 5 show a structure in accordance with the invention primarily used for/designed for outdoor use. The same advantages (flexibility and ease of service, repair) hold for these design as for the above design. It is remarked that due to said advantages use may be made of indoor BTS units in outdoor service protection structures, in which case a substantial advantage is obtained.

As far as outdoor structures are concerned it may seem at first instance that the requirement of space is less of a problem then indoor since there seem to be more room. However the most need for such units is in heavily populated areas which usually mean heavily built-up area. Often the units are placed on roof tops or similar surfaces. Accessibility of such places leaves much to be desired. Because of the modular approach of the invention, i.e. the unit substantially being built up of relatively small cabinets, places which could not be used for units or which required an outdoor housing for radio equipment and an indoor housing for the supporting equipment can now be used.

Fig. 3 show an open frontal view of an outdoor unit. The outdoor unit comprises a separate compartment in which batteries 31 are provided in a sliding tray. The tray prevents battery fluid, if a leak occurs, from entering cabinet 2. The cabinets 2 and 3 are in this embodiment, which is especially of advantage for outdoor units separated from each other by a metal separating wall 32. Through said wall signal or cable throughputs are provided. Such metal walls reduce cross-talk between the two cabinets. To further reduce cross-talk filters may be provided in the signal or cable throughputs. The unit is capped by a metal upper part 33, made of one piece. Such part is preferably custom made for each configuration of cabinets. The metal cap in one piece not only provide further shelter from stray electro-magnetic fields but also provided protection for the cabinets from rain and other weather condition. Having a limited number of standard caps enables an extension 3', 3" to be placed very quickly. Schematically indicated in figure 3 are different BTS units. In this preferred embodiment the door and the relevant cabinet is arranged for accommodating several types, preferably all radio equipment units. In practice this means that, compared to such radio equipment units (BTS units), the dimensions of the door, cabinet and slide are oversized. This allows the BTS units to be placed in and taken out of the unit as a single unitary assembly, which greatly increases flexibility. Preferably the cabinet 3 is provided with a slide for the radio equipment more in particular for the unitary assemblies. Such a slide enables the BTS assemblies to be easily and swiftly taken out, serviced and replaced.

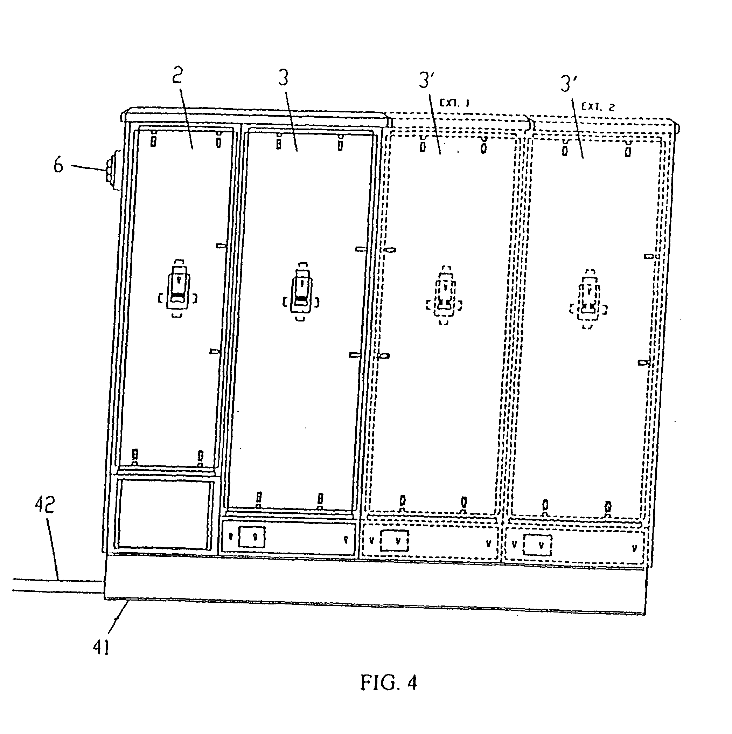

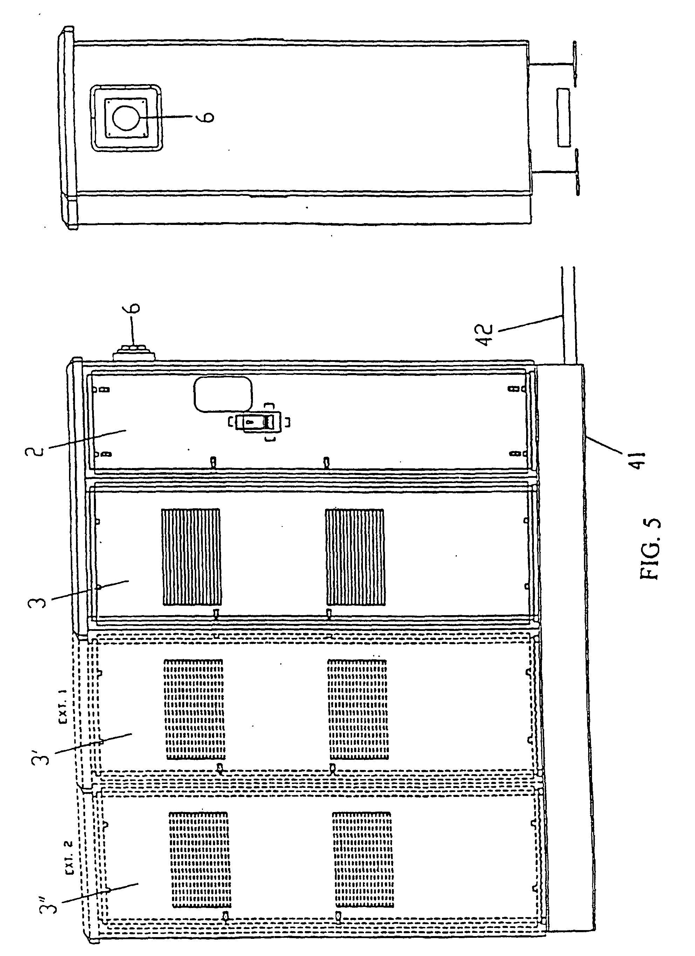

Cabinets 3 preferably have a storage part 34 which is slidable and in which preferably a canvas is stored. Such canvas can be used to protect the unit from rain when the doors have to be opened. Figure 4 shows a frontal view with closed doors. Preferably the structure is placed on a hollow beam, for instance a I-beam 41. Through said I-beam cables and supply lines 42 may be led to the structure. The throughputs of said cables are preferably substantially airtight and a fire detection system, a CO₂ or inert gas fire extinguisher system is provided inside the structure. Finally Fig. 5 gives a back view and a side view of an outdoor structure.

For both indoor and outdoor structures it holds that should the need arise to remove the structure this can easily be done.

In short the invention can be described by:

A service protection structure housing cell equipment is basically constituted by a number of metal cabinets, placed and joined to form substantially a cage of Faraday. One of the units comprise radio equipment and preferably only the radio equipment, another one houses the supporting equipment (including supply equipment such as for instance batteries). Preferably the cabinet for the radio equipment is arranged such that several types of radio equipment can be accommodated. Preferably said cabinet is provided with a slide for such radio equipment.

It will be clear that within the concept of the invention many variations are possible.

## Claims

1. A service protection structure, SPE, (1) housing cell equipment for cellular telephones including radio equipment and supporting equipment for providing protection of said cell equipment, **characterised in that** the unit comprises two or more separately movable cabinets (2,3, 3'), the outer sides of which are substantially made of metal material, a first of said cabinets housing the radio equipment (BTS), a second of said cabinets housing the supporting equipment, each cabinet having means to join a side of said cabinet to a corresponding side of another of the cabinets and each of the cabinets having means for cables going from said cabinet to an adjoining cabinet through the joining sides, the assembly of the cabinets substantially forming the service protection structure.

2. A service protection structure as claimed in claim 1, **characterised in that** the cabinet housing the radio equipment is arranged for accommodating several types of radio equipment units.

3. A service protection structure as claimed in claim 1 or 2, **characterised in that** the radio equipment is arranged in a (BTS) unitary assembly which unitary assembly is removably arranged within the relevant cabinet.

4. A service protection structure as claimed in any of the preceding claims, **characterised in that** the joining sides are substantially made of metal material.

5. A service protection structure as claimed in any of the preceding claims, **characterised in that** the cabinets comprise wall elements and a frame which are detachable from and attachable to each other by means of reversible attachment means.

6. A service protection structure as claimed in any of the preceding claims, **characterised in that** the first of said cabinets houses the radio equipment but not supporting equipment or electrical supply equipment.

7. A service protection structure as claimed in claim 6, **characterised in that** the radio equipment is placed on a slide.

8. A service protection structure as claimed in any of the preceding claims, **characterised in that** it is an indoor service protection structure.

9. A service protection structure as claimed in any of the preceding claims, **characterised in that** it is an outdoor service protection structure.

10. A service protection structure as claimed in claim 9, **characterised in that** over the cabinets a metal cap (33) is placed.

11. A service protection structure as claimed in any of the preceding claims, **characterised in that** the cabinets are provided with means for lifting the cabinets.

## Patentansprüche

1. Betriebsschutzaufbau SPE, (1), welche Relaisstationsausrüstung für Mobiltelefone unter Einschluss von Funkausrüstung und Hilfsausrüstung untergebracht hat, zum Bereitstellen von Schutz der Relaisstationsausrüstung, **dadurch gekennzeichnet, dass** die Einheit zwei oder mehr getrennt bewegliche Schränke (2, 3, 3') aufweist, deren Außenseiten im wesentlichen aus Metallmaterial hergestellt sind, wobei ein erster der Schränke die Funkausrüstung (BTS) in sich trägt, ein zweiter der Schränke die Hilfsausrüstung in sich trägt, wobei jeder Schrank Mittel zum Zusammenfügen einer Seite des Schrankes mit einer entsprechenden Seite eines anderen der Schränke aufweist und jeder der Schränke Mittel für Kabel aufweist, die vom Schrank zu einem angefügten Schrank durch die aneinander stoßenden Seiten hindurch verlaufen, wobei der Zusammenbau der Schränke im wesentlichen den Betriebsschutzaufbau ausbildet.

2. Betriebsschutzaufbau nach Anspruch 1, **dadurch gekennzeichnet, dass** der Schrank, welcher die Funkausrüstung in sich trägt, zum Aufnehmen mehrerer Typen von Funkausrüstungseinheiten angeordnet ist.

3. Betriebsschutzaufbau nach Anspruch 1 oder 2, **dadurch gekennzeichnet, dass** die Funkausrüstung in einer (BTS) einheitlichen Baugruppe angeordnet ist, wobei die einheitliche Baugruppe innerhalb des entsprechenden Schrankes entfernbar angeordnet ist.

4. Betriebsschutzaufbau nach einem der vorangehenden Ansprüche, **dadurch gekennzeichnet, dass** die aneinander stoßenden Seiten im wesentlichen aus Metallmaterial hergestellt sind.

5. Betriebsschutzaufbau nach einem der vorangehenden Ansprüche, **dadurch gekennzeichnet, dass** die Schränke Wandelemente und einen Rahmen umfassen, welche mittels reversibler Anbringungsmittel abnehmbar voneinander und anbringbar aneinander sind.

6. Betriebsschutzaufbau nach einem der vorangehenden Ansprüche, **dadurch gekennzeichnet, dass** der erste der Schränke die Funkausrüstung in sich trägt, nicht aber die Hilfsausrüstung oder die elektrische Versorgungsausrüstung.

7. Betriebsschutzaufbau nach Anspruch 6, **dadurch gekennzeichnet, dass** die Funkausrüstung auf einem Einschub angeordnet ist.

8. Betriebsschutzaufbau nach einem der vorangehenden Ansprüche, **dadurch gekennzeichnet, dass** er ein Innenraumbetriebsschutzaufbau ist.

9. Betriebsschutzaufbau nach einem der vorangehenden Ansprüche, **dadurch gekennzeichnet, dass** er ein Betriebsschutzaufbau für den Einsatz im Freien ist.

10. Betriebsschutzaufbau nach Anspruch 9, **dadurch gekennzeichnet, dass** über die Schränke eine Metallhaube (33) angeordnet ist.

11. Betriebsschutzaufbau nach einem der vorangehenden Ansprüche, **dadurch gekennzeichnet, dass** die Schränke mit Mitteln zum Anheben der Schränke ausgerüstet sind.

## Revendications

1. Structure de protection de service, SPE, (1), abritant un équipement cellulaire pour des téléphones cellulaires comprenant un équipement radio et un équipement auxiliaire, destinée à procurer une protection dudit équipement cellulaire, **caractérisée en ce que** l'unité comprend deux ou plusieurs armoires déplaçables séparément (2, 3, 3'), dont les parois latérales extérieures sont essentiellement faites en matériau métallique, une première desdites armoires abritant l'équipement radio (BTS), une seconde desdites armoires abritant l'équipement auxiliaire, chaque armoire ayant des moyens pour joindre une paroi latérale de ladite armoire à une paroi latérale correspondante d'une autre des armoires et chacune des armoires ayant des moyens pour des câbles allant de ladite armoire à une armoire contiguë au travers des parois latérales se joignant, l'ensemble des armoires formant essentiellement la structure de protection de service.

2. Structure de protection de service selon la revendication 1, **caractérisée en ce que** l'armoire abritant l'équipement radio est agencée pour accepter plusieurs types d'unités d'équipements radio.

3. Structure de protection de service selon la revendication 1 ou 2, **caractérisée en ce que** l'équipement radio est agencé en un ensemble unitaire (BTS), lequel ensemble unitaire est agencé dans l'armoire correspondante de façon à pouvoir être enlevé.

4. Structure de protection de service selon l'une quelconque des revendications précédentes, **caractérisée en ce que** les parois latérales se joignant sont essentiellement faites en matériau métallique.

5. Structure de protection de service selon l'une quelconque des revendications précédentes, **caractérisée en ce que** les armoires comprennent des éléments de parois et un châssis qui peuvent être détachés et attachés l'un à l'autre à l'aide d'un moyen de fixation réversible.

6. Structure de protection de service selon l'une quelconque des revendications précédentes, **caractérisée en ce que** la première desdites armoires abrite l'équipement radio mais pas d'équipement auxiliaire ni d'équipement d'alimentation électrique.

7. Structure de protection de service selon la revendication 6, **caractérisée en ce que** l'équipement radio est placé sur une glissière.

8. Structure de protection de service selon l'une quelconque des revendications précédentes, **caractérisée en ce que** c'est une structure de protection de service pour l'intérieur.

9. Structure de protection de service selon l'une quelconque des revendications précédentes, **caractérisée en ce que** c'est une structure de protection de service pour l'extérieur.

10. Structure de protection de service selon la revendication 9, **caractérisée en ce qu'**un capot en métal (33) est placé au-dessus des armoires.

11. Structure de protection de service selon l'une quelconque des revendications précédentes, **caractérisée en ce que** les armoires sont pourvues de moyens pour lever les armoires.
